# EUROPÄISCHE PATENTSCHRIFT

(11) **EP 2 160 669 B1**
(45) Veröffentlichungstag und Bekanntmachung des Hinweises auf die Patenterteilung: **04.12.2019**
(21) Anmeldenummer: 08773468.7
(22) Anmeldetag: 16.06.2008
(51) Int. Cl.: H01L 27/02, H01L 27/088, G05F 3/26

(54) **STROMSPIEGEL MIT SELBSTLEITENDEM TRANSISTOR**
CURRENT MIRROR WITH A SELF-CONDUCTING TRANSISTOR
MIROIR DE COURANT À TRANSISTOR NORMALEMENT CONDUCTEUR

(30) Priorität: 18.06.2007 DE 102007028459; 18.06.2007 DE 102007028461
(43) Veröffentlichungstag der Anmeldung: 10.03.2010
(73) Patentinhaber: AZUR SPACE Solar Power GmbH, 74072 Heilbronn (DE); Institut für Mikroelektronik Stuttgart, 70569 Stuttgart (DE)
(72) Erfinder: DAUMILLER, Ingo, 89165 Dietenheim/Reggisweiler (DE); SÖNMEZ, Ertugrul, 89075 Ulm (DE); KUNZE, Mike, 89284 Pfaffenhoffen (DE)
(74) Vertreter: Witte, Weller & Partner Patentanwälte mbB
(86) Internationale Anmeldenummer: PCT/EP2008/004837
(87) Internationale Veröffentlichungsnummer: WO 2008/155084

(56) Entgegenhaltungen:
- EP-A- 0 790 699
- US-A- 3 953 807
- US-A- 4 896 121

## Beschreibung

Die Erfindung betrifft einen Stromspiegel mit zumindest einem selbstleitenden Transistor sowie eine elektrische Schaltung mit einem solchen Stromspiegel.

Ein Stromspiegel ist eine Schaltung, welche einen Ausgangsstrom erzeugt, dessen Stromstärke zur Stromstärke eines Eingangsstromes in einem im Wesentlichen festen Verhältnis steht. Ein solcher Stromspiegel kann eine nieDrlge Eingangs- und eine hohe Ausgangsimpedanz haben. Stromspiegel werden sowohl als Stromverstärker als auch zur Steuerung- und Arbeitspunkteinstellung in der analogen und digitalen Schaltungstechnik verwendet.

Ein Stromspiegel ist wie folgt aufgebaut. Ein Stromspiegel weist einen Referenztransistor auf, dessen Drain- und Gate-Kontakt miteinander unmittelbar elektrisch verbunden sind. Ein Gate-Kontakt des Referenztransistors ist elektrisch unmittelbar kontaktiert mit einem Gate-Kontakt eines Spiegeltransistors. Fließt nun ein Eingangsstrom Iᵢₙ in den Drain- Kontakt des Referenztransistors und damit auch in den Gate-Kontakt des Referenztransistors, so fließt auch ein Strom in den Gate-Kontakt des Spiegeltransistors. Der Referenztransistor öffnet und zwischen dem Gate-Kontakt und einem Source-Kontakt des Transistors fällt eine Spannung ab. Hierdurch fließt in einem Drain-Kontakt des Spiegeltransistors ein Ausgangsstrom Iₒᵤₜ Der Ausgangsstrom Iₒᵤₜ steht hierbei in einem im Wesentlichen konstanten Verhältnis zu dem Eingangsstrom Iᵢₙ, welcher in den Drain-Kontakt des Referenztransistors und den Gate-Kontakt des Referenztransistors sowie den Gate-Kontakt des Spiegeltransistors fließt. Für einen gegebenen eingeprägten Strom Iᵢₙ baut sich also im Referenztransistor die Gate-Source-Spannung auf, welche vom Spiegeltransistor gemessen wird. Der sich im Spiegeltransistor einstellende Ausgangsstrom Iₒᵤₜ steht zum Eingangsstrom Iᵢₙ in einem Verhältnis, welches dem Verhältnis von Flächen der Transistoren zueinander gleich ist.

Nach dem Stand der Technik werden derartige Stromspiegel mittels Silizium-basierten Transistoren realisiert. Nachteilig hierbei ist jedoch, dass hierdurch der Stromspiegel nur bei niedrigen Temperaturen und geringen Stromstärken betreibbar ist.

US 4 896 121 A offenbart eine Stromspiegeltechnik für depletion-mode-Feldeffekttransistor-Technologie. Diese verwendet eine Diodenpegelverschiebungsschaltung zwischen dem Drain und dem Gate eines ersten depletion-mode-Feldeffekttransistors (FET), um seine Gate-Spannung unterhalb ihrer Drain-Spannung zu halten. Das Gate des ersten depletion-mode-FET ist mit dem Gate eines zweiten depletion-mode-FET verbunden. Eine Stromquelle wird verwendet, um den von der Pegelverschiebungsschaltung gezogenen Strom zu kompensieren. Die Stromquelle enthält vorzugsweise einen FET und mindestens eine Schottky-Diode.

EP 0 790 699 A2 offenbart ein Verfahren zum Ansteuern eines Gleichstrommotors (M) über eine integrierte H-Brückenschaltung mittels einer Steuerschaltung (ST), wobei der jedem Motoranschluß (Out1, Out2) zugeordnete highside-Transistorschalter (T1, T2) oder lowside-Transistorschalter (T4, T3) oder beide über je eine Schutzschaltung (S1, S2) in den leitenden Zustand gesteuert oder geregelt wird/werden, wenn und solange das Potential (Vout1, Vout2) an diesem Motoranschluß (Out1, Out2) einen vorgegebenen Wert (-0,5 V) unterschreitet. Jede Schutzschaltung weist einen vorgespannten Transistor (Q1, Q2) auf, in dessen leitendem Zustand die zugeordneten Transistorschalter über einen Stromspiegel leitend gesteuert werden.

US 3 953 807 A offenbart einen dreipoligen Stromverstärker mit einer Stromverstärkung, die im Wesentlichen unabhängig von den Vorwärtsstromverstärkungen seiner FETs ist. Ein erster und zweiter FET haben Source-Elektroden, die an den gemeinsamen Anschluss des Verstärkers angeschlossen sind. Ein dritter FET hat seine Source-Elektrode mit der Drain-Elektrode des zweiten FET verbunden und seine Gate- und Drain-Elektroden mit dem Eingangsanschluss bzw. dem Ausgangsanschluss des Verstärkers verbunden. Die Gate-Elektroden des ersten und zweiten FETs und der ersten FET-Drain-Elektrode sind mit dem Eingangsanschluss über eine Potentialquelle gekoppelt, die ein Offset-Potential liefert, das kleiner ist als das Source-to-Gate-Potential eines FETs, wodurch die erforderlichen Potentiale zwischen dem gemeinsamen Anschluss und jedem der Eingangs- und Ausgangsanschlüsse im Vergleich zu solchen FET-Verstärkern nach dem Stand der Technik reduziert werden können.

Aufgabe der vorliegenden Erfindung ist es daher, einen Stromspiegel anzugeben, welcher sowohl bei höheren Temperaturen als auch mit hohen Stromstärken betrieben werden kann.

Diese Aufgabe wird gelöst durch den Stromspiegel nach Anspruch 1 und die elektrische Schaltung nach Anspruch 8. Vorteilhafte Weiterbildungen des erfindungsgemäßen Stromspiegels und der erfindungsgemäßen elektrischen Schaltung werden durch die jeweiligen abhängigen Ansprüche gegeben.

Erfindungsgemäß wurde erkannt, dass ein Stromspiegel realisiert werden kann, welcher bei hohen Temperaturen und mit hohen Stromstärken betreibbar ist, wenn anstelle von Siliziumtransistoren selbstleitende Transistoren eingesetzt werden. Erfindungsgemäß ist daher ein Stromspiegel mit zumindest zwei Transistoren, wobei zumindest einer der beiden Transistoren ein selbstleitender Transistor ist. Vorzugsweise ist hierbei der zumindest eine selbstleitende Transistor ein selbstleitender n-Kanal-Transistor oder ein selbstleitender p-Kanal-Transistor.

Gerade für den Einsatz bei hohen Temperaturen sind hierbei selbstleitende Transistoren besonders geeignet, welche zumindest einen Halbleiter aufweisen, der zumindest ein Nitrid eines Hauptgruppe-III-Elementes enthält oder daraus besteht. Vorzugsweise enthält oder besteht hierbei ein Kanal des Transistors aus dem Nitrid eines Hauptgruppe-III-Elementes. Geeignete Materialien können also z.B. GaN, InN, AlN, GaAlN, GaInN und GaAlInN sein.

Ein solcher Transistor kann eine Quelle oder Source, eine Senke oder Drain sowie ein Gate aufweisen. Besonders vorteilhaft lassen sich hier Feldeffekttransistoren (FET), insbesondere Sperrschicht-Feldeffekttransistoren (RFET) realisieren.

Vorteilhafterweise können die folgenden Transistortypen zum Einsatz kommen. Zum einen können Heterostruktur-Transistoren, wie HEMT oder HFET, MODFET oder MOSHFET verwendet werden. In solchen Transistoren wird ein leitfähiger Kanal im Wesentlichen dadurch erzeugt, dass zwei Hauptgruppe-III-Nitrid-basierende Schichten aufgrund ihrer Verspannungen zueinander (Polarisationseffekt) einen leitfähigen Kanal aus einem zweidimensionalen Elektronengas (2DEG) an ihrer Grenzfläche erzeugen. Hierdurch entsteht im Kanal Leitfähigkeit ohne äußere Dotierung. Zur Herstellung solcher Transistoren wird auf einem Substrat zunächst eine (Al) (Ga) (In) -N-basierende Schicht, der sog. Puffer, aufgebracht, auf dem dann wiederum eine dünne (Al) (Ga) (In)-N-basierende Schicht aufgebracht wird. Mit Hilfe von zwei Ohmschen Kontakten (Source und Drain) kann dann das zweidimensionale Elektronengas kontaktiert werden. Die Steuerung der Ladungsträger bzw. eine Modellation der Dichte der Ladungsträger kann hier durch ein Gate erfolgen, das zwischen den Ohmschen Kontakten angeordnet ist. Ein Beispiel für einen solchen Transistor ist ein AlGaN/GaN HEMT. Hier ist dann GaN der Puffer, während das Substrat z.B. Silizium sein kann.

Derartige Heterostrukturen können auf verschiedene Weise abgewandelt sein. Es können z.B. die einzelnen Schichten unterschiedlich dotiert sein oder nur partiell in Dotierspikes dotiert sein, wie z.B. beim MODFET. Darüber hinaus ist es möglich, dass unter der Gate-Diode ein Isolator platziert ist. Man spricht dann von einem sog. MOS (Metal Oxide Semiconductor), MIS (Metal Isolation Semiconductor) Transistor oder HEMT. Dieser wird bei GaN auch MOSHFET genannt.

Vorzugsweise sind diese Transistortypen selbstleitend (normally-on), d.h. bei einer Gatespannung von 0 V bzw. bei keiner angelegten Spannung am Gate fließt ein Strom zwischen Source und Drain.

Prinzipiell ist es aber möglich, mit GaN und deren Verbindungen normally-off, d.h. selbstsperrende Transistoren herzustellen. Dabei wird in der Schichtfolge die Zusammensetzung der Materialien (mit In, Ga, Al oder N) zueinander angepasst, so dass bei fehlender Gate-Spannung zwischen Source und Drain kein Strom fließt. Ein Stromfluss ergibt sich dann, wenn das Gate, z.B. bei einem n-Typ Transistor zu positiven Werten angesteuert wird.

Eine weitere Möglichkeit, einen selbstsperrenden Transistor zu realisieren, besteht darin, bei einem klassischen selbstleitenden Transistor unter dem Gatemetall die darunterliegende Halbleiterschicht zu ätzen (z.B. in das AlGaN), so dass diese Schicht unter dem Gate dünner wird (es entsteht ein GateRecess). Bei einer geeigneten Dicke kann dann ein selbstsperrender Transistor entstehen.

Eine andere Klasse von Transistoren sind Transistoren ohne Heterostruktur, wie beispielsweise MESFET oder delta-doped MESFET. Die Leitfähigkeit dieser Transistoren wird durch eine Dotierung im Volumenmaterial von (Ga) (Al) (In) -Nitrid eingestellt. Die Dotierung kann sich hierbei wie beim MESFET im Volumen befinden oder durch einen Dotierpuls platziert werden wie beim delta-doped MESFET. Auch hier können wieder Isolatoren unter dem Gate zum Einsatz kommen. Auch hier sind normally-off und normally-on Typen möglich. Bei allen genannten Transistortypen können sowohl n- als auch p-Kanaltransistoren realisiert werden.

Besonders bevorzugt ist es, wenn der Stromspiegel so ausgebildet ist, dass sich der Ausgangsstrom Iₒᵤₜ des Stromspiegels in einem Bereich zwischen 0 A und einem Maximalström bewegt, wenn sich der Eingangsstrom Iᵢₙ in einem Bereich zwischen 0 A und einem maximalen Eingangsstrom bewegt. Dies kann besonders bevorzugt dadurch erreicht werden, dass ein Drain-Kontakt eines Referenztransistors des Stromspiegels mit einem Gate-Kontakt des Referenztransistors über zumindest eine Diode, bevorzugt über zwei in Serie geschaltete Dioden, elektrisch verbunden wird, wobei vorzugsweise die Verbindung außer Dioden keine weiteren elektrischen Bauelemente aufweist.

Besonders bevorzugt ist es außerdem, wenn zumindest eine Diode, vorzugsweise zwei in Serie geschaltete Dioden, mit einem Source-Kontakt oder einem Drain-Kontakt des Referenztransistors und/oder des Spiegeltransistors, bevorzugt jedoch eines der selbstleitenden Transistoren, in Kontakt steht, wobei wiederum zwischen dem entsprechenden Kontakt und jener dem Transistor nächstliegenden Diode kein weiteres elektrisches Bauelement angeordnet ist.

Hier ist also zumindest eine Diode Dr1, vorzugsweise zwei in Serie geschaltete Dioden Dr1 und Dr2, mit einem Source-Kontakt oder einem Drain-Kontakt des Referenztransistors kontaktiert, vorzugsweise elektrisch unmittelbar kontaktiert. Bevorzugt ist außerdem zumindest eine Diode Ds1, vorzugsweise zwei in Serie geschaltete Dioden Ds1 und Ds2 mit einem Source-Kontakt des Spiegeltransistors kontaktiert, vorzugsweise elektrisch unmittelbar kontaktiert. Für eine genaue Einstellung des Nullpunktes ist es vorteilhaft, wenn das Verhältnis der Fläche der Diode Dr1 zur Fläche der Diode Ds1 gleich der Fläche des Spiegeltransistors zur Fläche des Referenztransistors ist. Werden zwei Dioden eingesetzt, so ist vorteilhafterweise auch die Fläche der Diode Dr2 zur Fläche der Diode Ds2 gleich dem Verhältnis der Fläche des Spiegeltransistors zur Fläche des Referenztransistors.

In einer weiteren vorteilhaften Ausgestaltung weist der Stromspiegel zumindest einen Bypass-Transistor auf, dessen Drain-Kontakt mit einem Gate-Kontakt zumindest eines der Transistoren, vorzugsweise des Referenztransistors und/oder des Spiegeltransistors, kontaktiert ist, vorzugsweise elektrisch unmittelbar kontaktiert ist, wobei ein Gate-Kontakt des Bypass-Transistors mit dem Source-Kontakt dieses Bypass-Transistors kurzgeschlossen ist.

Jene ein oder mehrere Dioden, welche in der Kontaktierung des Drain-Kontaktes des Referenztransistors mit dem Gate-Kontakt des Referenztransistors angeordnet sind, heben das Drain-Potential des Referenztransistors um die Summe der Diodenspannungen gegenüber dem Gate-Potential des Referenztransistors an. Damit sich die Diodenspannungen über diese Dioden aufbauen können, ist es bevorzugt, einen Bypassstrom I_{b} aufzubauen. Dies kann durch den Bypass-transistor Tb erreicht werden, wobei die Stromstärke des Bypassstromes durch die Größe der Fläche des Transistors Tb eingestellt werden kann. Da der Bypasstransistor zwischen den Gate-Kontakten von Referenzund Spiegeltransistor einerseits und beispielsweise einer Masse andererseits angeordnet ist, fehlt dem zu spiegelnden Eingangsstrom Iᵢₙ der Spiegelstrom I_{b}. Damit sich am Gate-Kontakt des Referenztransistors ein negativeres Potential als am Source-Kontakt des Referenztransistors einstellen kann, kann das Source-Potential des Referenztransistors mit dem Source-Kontakt des Referenztransistors nachgeschalteten ein oder mehreren Dioden Dr1 und Dr2 um die Summe der Diodenspannungen der nachgeschalteten Dioden angehoben werden, so dass der Referenztransistor auch vollständig abgeschaltet werden kann. Die durch (Iᵢₙ-I_{b}) erzeugte Referenzspannung ist hier die absolute Gate-Spannung des Referenztransistors, die sich aus seiner Gate-Source-Spannung und den Diodenspannungen der ein oder mehreren den Source-Kontakt des Referenztransistor nachgeschalteten Dioden additiv zusammensetzt. Damit der Ausgangsstrom dem Eingangsstrom Iᵢₙ minus dem Bypassstrom I_{b} multipliziert mit dem Flächenverhältnis der Fläche des Spiegeltransistors zur Fläche des Referenztransistors folgen kann, werden vorzugsweise die Verhältnisse der Flächen der Dioden so eingestellt, dass diese Verhältnisse gleich dem Verhältnis der Fläche des Spiegeltransistors zur Fläche des Referenztransistors ist. Ist der Eingangsstrom Iᵢₙ grösser als der Bypassstrom I_{b}, so kann der Ausgangsstrom Iₒᵤₜ dem Eingangsstrom Iᵢₙ entsprechend der Gleichung (Iᵢₙ-I_{b})^{∗}Aₛ/Aᵣ=Iₒᵤₜ folgen. Die Schaltung kann so eingestellt werden, dass für Iᵢₙ gegen 0 A auch Iₒᵤₜ gegen 0 A geht. Für Eingangsströme kleiner dem nominellen Wert des Bypassstromes wird normalerweise aber der Ausgangsstrom nicht mehr dieser Gleichung genügen.

Die Anzahl der zur Potentialverschiebung eingesetzten, in Serie geschalteten Dioden ist nicht auf eins oder zwei begrenzt. Vorzugsweise wird vielmehr die Zahl der in Serie geschalteten Dioden entsprechend einer Pinch-Off-Spannung der eingesetzten selbstleitenden Transistoren gewählt.

Es ist nicht unbedingt notwendig, dass der Bypassstrom I_{b} vom Eingangsstrom Iᵢₙ gespeist wird. Wird der Bypassstrom anders zur Verfügung gestellt, so werden vorzugsweise auch die Dioden anders angeordnet. Erfindungsgemäß ist außerdem eine elektrische Schaltung, welche den oben beschriebenen Stromspiegel aufweist. Diese elektrische Schaltung weist neben dem Stromspiegel zumindest ein weiteres elektrisches Bauelement auf. Dieses weitere Bauelement kann zum Beispiel ein weiterer Transistor sein, der vorzugsweise einen Halbleiter mit einem Nitrid eines Hauptgruppe-III-Elementes aufweist.

Besonders bevorzugt enthält die elektrische Schaltung zumindest eine halbe H-Brücke mit zumindest einem ersten weiteren Transistor und zumindest einem zweiten weiteren Transistor, wobei ein Source-Kontakt des einen der weiteren Transistoren mit einem Drain-Kontakt des anderen der weiteren Transistoren kontaktiert ist, vorzugsweise elektrisch unmittelbar kontaktiert ist. Eine solche Serienschaltung von Transistoren ist typischerweise Bestandteil einer halben H-Brücke. Ein durch die halbe H-Brücke angesteuerter Verbraucher kann dann am Source-Kontakt des einen und/oder am Drain-Kontakt des anderen der weiteren Transistoren angeordnet sein. Für den Fall, dass die elektrische Schaltung eine ganze H-Brücke aufweist, ist der andere Pol des Verbrauchers entsprechend mit einer weiteren halben H-Brücke kontaktiert.

Weist die elektrische Schaltung zwei halbe H-Brücken mit jeweils einem ersten weiteren Transistor und zumindest einem zweiten weiteren Transistor auf, welche zu einer ganzen H-Brücke gekoppelt sind, so sind vorzugsweise die Source-Kontakte der ersten weiteren Transistoren elektrisch miteinander kontaktiert, vorzugsweise elektrisch unmittelbar kontaktiert und sind außerdem jene Kontakte der zweiten weiteren Transistoren, welche nicht mit dem jeweils ersten weiteren Transistor der entsprechenden halben H-Brücke verbunden sind, miteinander kontaktiert, vorzugsweise miteinander elektrisch unmittelbar kontaktiert.

Besonders bevorzugt ist es, wenn der Source- und der Drain-Kontakt des ersten und/oder des zweiten weiteren Transistors zumindest einer der halben H-Brücken über jeweils zumindest eine Freilaufdiode miteinander elektrisch verbunden sind, vorzugsweise über diese Diode elektrisch unmittelbar verbunden sind.

Vorzugsweise ist nun ein Gate-Kontakt des ersten und/oder des zweiten weiteren Transistors zumindest einer halben H-Brücke mit einem Drain-Kontakt eines Spiegeltransistors eines der Stromspiegel verbunden, vorzugsweise elektrisch unmittelbar. Auf diese Weise kann der Gate-Strom der weiteren Transistoren der H-Brücke über den entsprechenden Strom-Spiegel gesteuert werden. Vorzugsweise sind vor den Gate-Kontakten aller der weiteren Transistoren entsprechend je ein Stromspiegel angeordnet.

Bevorzugterweise ist in der elektrischen Schaltung zumindest ein Kondensator angeordnet, welcher jene Sourceoder Drain-Kontakte des ersten weiteren und des zweiten weiteren Transistors zumindest einer der halben H-Brücken miteinander kontaktiert, vorzugsweise elektrisch unmittelbar miteinander kontaktiert, welche nicht mit dem jeweils anderen Transistor der gleichen halben H-Brücke kontaktiert sind.

Die oben beschriebenen Freilaufdioden und der zumindest eine Kondensator schützen die elektrische Schaltung von negativen Überspannungsspitzen und verbessern die Spannungsquelleneigenschaften an den Spannungsversorgungspunkten. Dies ist insbesondere wichtig, wenn die elektrische Schaltung als integrierte Schaltung ausgeführt wird.

Ein weiterer Kondensator kann einen Source- oder Drain-Kontakt des ersten oder zweiten weiteren Transistors zumindest einer der halben H-Brücken kontaktieren, vorzugsweise elektrisch unmittelbar kontaktieren, der nicht mit dem jeweils anderen weiteren Transistor dieser halben H-Brücke kontaktiert ist. Dieser Kondensator kontaktiert dann andererseits einen Kontakt einer am Source-Kontakt eines Spiegeltransistors eines der Stromspiegel angeordneten Dioden, welcher Kontakt nicht mit dem entsprechenden Spiegeltransistor oder einer anderen am Source-Kontakt dieses Spiegeltransistors angeordneten Diode in Kontakt ist. Sind keine derartigen Dioden vorgesehen, so kann dieser Kondensator einen Source-Kontakt eines der Spiegeltransistoren kontaktieren, an welchem der entsprechende Spiegeltransistor nicht mit einem der weiteren Transistoren oder einer Diode in Kontakt steht.

In einer besonders bevorzugten Ausführungsform weist zumindest eine der halben H-Brücken mehrere erste weitere zueinander parallel geschaltete Transistoren und/oder mehrere zweite weitere zueinander parallel geschaltete Transistoren auf, wobei die Transistoren vorzugsweise parallel geschaltet sind, indem ihre Drain-Kontakte miteinander verbunden sind und ihre Source-Kontakte miteinander verbunden sind, vorzugsweise elektrisch unmittelbar verbunden sind.

Die elektrische Schaltung kann generell eine Mehrzahl von parallel geschalteten Bauelementen mit jeweils zumindest einem Kontakt einer ersten Funktion und zumindest einem Kontakt einer zweiten Funktion aufweisen, wobei jeweils ein Kontakt der ersten Funktion unmittelbar benachbart zu einem Kontakt der zweiten Funktion angeordnet ist. In diesem Falle sind also die Kontakte verschiedener Funktionen miteinander vermischt bzw. ineinander verschachtelt. Vorzugsweise sind benachbart angeordnete Kontakte unmittelbar aneinander angrenzend angeordnet, wobei jedoch zwischen den Kontakten jeweils eine Isolierung angeordnet sein kann.

Die elektrische Schaltung kann vorteilhaft zumindest einen Kondensator aufweisen, welcher jene Source- oder Drain-Kontakte des ersten weiteren und des zweiten weiteren Transistors zumindest einer der halben H-Brücken miteinander kontaktiert, vorzugsweise elektrisch unmittelbar kontaktiert, welche nicht mit dem jeweils anderen Transistor der gleichen halben H-Brücke kontaktiert sind.

Auch kann die elektrische Schaltung zumindest einen Kondensator aufweisen, welcher einen Source-Kontakt des ersten oder zweiten weiteren Transistors zumindest einer der halben H-Brücken kontaktiert, vorzugsweise elektrisch unmittelbar kontaktiert, der nicht mit dem jeweils anderen weiteren Transistor dieser halben H-Brücke kontaktiert ist, vorzugsweise elektrisch unmittelbar kontaktiert ist, und welcher einen Kontakt einer am Source-Kontakt eines Spiegeltransistors eines der Stromspiegel angeordneten Diode kontaktiert, welcher nicht mit dem entsprechenden Spiegeltransistor oder einer anderen am Source-Kontakt dieses Spiegeltransistors angeordneten Diode in Kontakt ist, oder welcher einen Source-Kontakt eines Spiegeltransistors kontaktiert, an welchem der entsprechende Spiegeltransistor nicht mit einem der weiteren Transistoren oder einer Diode in Kontakt steht.

Bevorzugt kann zumindest eine der halben H-Brücken mehrere erste weitere Transistoren, die zueinander parallel geschaltet sind, und/oder mehrere zweite weitere Transistoren, die zueinander parallel geschaltet sind, aufweisen, wobei die Transistoren vorzugsweise jeweils parallel geschaltet sind, indem ihre Drain-Kontakte miteinander verbunden sind und ihre Source-Kontakte miteinander elektrisch verbunden sind, vorzugsweise elektrisch unmittelbar verbunden sind.

Die elektrische Schaltung kann eine Mehrzahl von parallel geschalteten Bauelementen mit jeweils zumindest einem Kontakt einer ersten Funktion und zumindest einem Kontakt einer zweiten Funktion aufweisen, wobei jeweils ein Kontakt der ersten Funktion unmittelbar benachbart zu einem Kontakt der zweiten Funktion angeordnet ist.

Es können vorteilhaft zumindest einige der unmittelbar benachbarten Kontakte unmittelbar aneinander angrenzend angeordnet sein, wobei vorzugsweise zwischen diesen Kontakten jeweils eine Isolierung angeordnet ist.

Bevorzugterweise ist die Schaltung bei Strömen ≥ 1 A, vorzugsweise ≥ 2 A, vorzugsweise ≥ 10 A betreibbar.

Die Bauelemente können Transistoren sein, vorzugsweise können die Bauelemente auch die weiteren Transistoren der zumindest einen halben H-Brücke sein.

Die Schaltung oder der Stromspiegel gemäß der Erfindung sind unter anderem als Hochtemperaturbauelement, als Motorsteuerung, als Schaltnetzteil oder als Schaltverstärker verwendbar.

Besonders vorteilhaft bei der erfindungsgemäßen Schaltung ist, dass sie bei hohen Temperaturen betrieben werden kann, insbesondere bei Temperaturen größer als 100 °C, besonders bevorzugt größer als 200 °C, besonders bevorzugt größer als 400 °C, besonders bevorzugt größer als 600 °C. Darüber hinaus kann die elektrische Schaltung bei hohen Strömen, insbesondere ≥ 1 A, besonders bevorzugt ≥ 2 A, besonders bevorzugt ≥ 10 A betrieben werden.

Im Folgenden soll die Erfindung anhand einiger Figuren beispielhaft erläutert werden. Gleiche Bezugszeichen entsprechen hierbei analogen Elementen.

Es zeigt
- Figur 1: den grundsätzlichen Aufbau eines Stromspiegels,
- Figur 2: einen Stromspiegel entsprechend einer vorteilhaften Ausführungsform der vorliegenden Erfindung,
- Figur 3: eine halbe H-Brücke mit zwei Erfindungsgemäßen Stromspiegeln und
- Figur 4: eine ganze H-Brücke mit vier Erfindungsgemäßen Stromspiegeln.

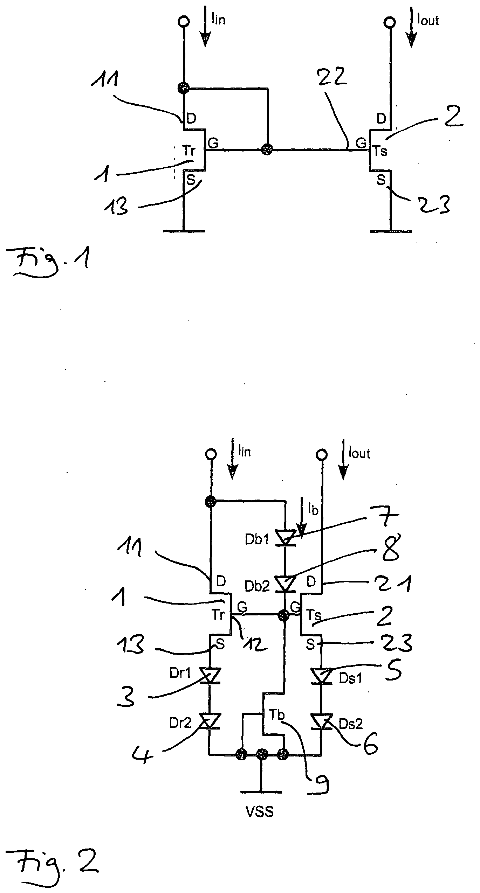

Figur 1 zeigt einen einfachen Stromspiegel, wie er in der vorliegenden Erfindung realisiert sein kann. Der Stromspiegel weist einen Referenztransistor 1 und einen Spiegeltransistor 2 auf. Zumindest einer dieser Transistoren ist selbstleitend. Im Referenztransistor 1 sind der Drain-Kontakt 11 und der Gate-Kontakt 12 dieses Transistors 1 kurzgeschlossen. Der Gate-Kontakt 12 des Referenztransistors 1 ist mit dem Gate-Kontakt 22 des Spiegeltransistors 2 verbunden. In den Drain-Kontakt 11 und den Gate-Kontakt 12 wird ein Eingangsstrom Iᵢₙ eingeprägt. Für den eingeprägten Strom Iᵢₙ baut sich im Referenztransistor 1 eine bestimmte Gate-Source-Spannung auf, welche dann vom Spiegeltransistor 2 gemessen wird. Der sich im Spiegeltransistor 2 aufbauende Ausgangsstrom Iₒᵤₜ steht zum Eingangsstrom Iᵢₙ in einem Verhältnis, welches gleich dem Verhältnis der Fläche des Spiegeltransistors As zur Fläche des Referenztransistors Aᵣ ist. Es gilt also I_{in/}Iₒᵤₜ=Aₛ/Aᵣ. Source-Kontakte 13 und 23 von Referenztransistor 1 und Spiegeltransistor 2 sind mit einer Masse elektrisch unmittelbar verbunden.

Figur 2 zeigt ein Beispiel für eine bevorzugte Ausführungsform eines Stromspiegels entsprechend der vorliegenden Erfindung. Wiederum sind ein Gate-Kontakt 12 eines Referenztransistors 1 mit einem Gate-Kontakt 22 eines Spiegeltransistors 2 elektrisch unmittelbar verbunden. Hier sind nun dem Source-Kontakt 13 des Referenztransistors 1 zwei Dioden 3 und 4 (Dr1 und Dr2) in Serie nachgeschaltet. Die Dioden 3 und 4 sind zueinander in Serie geschaltet und zwischen dem Source-Kontakt 13 des Referenztransistors 1 und der Masse angeordnet. Darüber hinaus sind zwei weitere Dioden 5 und 6 (Ds1 und Ds2) dem Source-Kontakt 22 des Spiegeltransistors 2 nachgeschaltet, also in Serie zwischen dem Source-Kontakt 23 und der Masse geschaltet. Zwischen dem Drain-Kontakt 11 des Referenztransistors 1 und den Gate-Kontakten 12 und 22 des Referenztransistors 1 und des Spiegeltransistors 2 sind nun wiederum zwei weitere Dioden 7 und 8 (Db1 und Db2) in Serie zwischengeschaltet. Darüber hinaus weist die Schaltung einen Bypasstransistor 9 auf, dessen Drain-Source-Strecke die Gates 12 und 22 des Referenztransistors und des Spiegeltransistors mit der Masse verbindet.

Die in Figur 2 gezeigte Schaltung funktioniert wie folgt. Während beim herkömmlichen Stromspiegel Drain-Kontakt 11 und Gate-Kontakt 12 des Referenztransistors 1 kurzgeschlossen sind, sind hier Drain-Kontakt 11 und Gate-Kontakt 12 über die beiden in Reihe geschalteten Dioden 7 und 8 verbunden. Diese beiden Dioden 7 und 8 heben das Drain-Potential des Referenztransistors 1 um zwei Diodenspannungen gegenüber dem Gate-Potential an. Damit sich über diesen Dioden 7 und 8 eine Spannung aufbauen kann, wird ein Bypassstrom I_{b} aufgebaut, dessen Stromstärke durch die Dimensionierung der Fläche des Bypasstransistors 9 Tb eingestellt wird. Dem zu spiegelnden Eingangsstrom Iᵢₙ fehlt damit der Bypassstrom I_{b}, welcher durch den Transistor 9 fließt. Damit sich am Gate-Kontakt 12 des Referenztransistors 1 ein negativeres Potential als am Source-Kontakt 13 dieses Transistors einstellen kann, wird das Source-Potential des Referenztransistors 1 mit den Dioden 3 und 4 um deren Diodenspannungen angehoben, so dass der Referenztransistor 1 auch komplett abgeschaltet werden kann, d.h. dass kein Strom aus dem Source-Kontakt 13 fließt. Die durch (Iᵢₙ-I_{b}) erzeugte Referenzspannung ist jetzt die absolute Gate-Spannung des Referenztransistors 1, welche sich aus einer Gate-Source-Spannung und den Diodenspannungen der Dioden 3 und 4 additiv zusammensetzt. Damit der Ausgangsstrom in den Drain-Kontakt 21 des Spiegeltransistors 2 einen Wert (Iᵢₙ-I_{b}) mal dem Flächenverhältnis Aₛ/Aᵣ der Fläche des Spiegeltransistors 2 Aₛ zur Fläche des Referenztransistors 1 Aᵣ folgen kann, müssen die Diodenflächenverhältnisse Ds1/Dr1 und Ds2/Dr2 gleich dem Transistorflächenverhältnis Aₛ/Aᵣ eingestellt werden. Für Iᵢₙ > I_{b} folgt der Ausgangsstrom Iₒᵤₜ dem Eingangsstrom Iin entsprechend der Gleichung (Iᵢₙ-I_{b})^{∗}Aₛ/Aᵣ=Iₒᵤₜ. Für Iᵢₙ gegen 0 A geht auch Iₒᵤₜ gegen 0 A. Zu beachten ist aber, dass für Eingangsströme, welcher kleiner als der nominelle Wert des Bypassstromes sind, der Ausgangsstrom nicht mehr dieser Gleichung genügt. Die Zahl der zur Potentialverschiebung eingesetzten, in Serie geschalteten Dioden 3, 4, 5, 6, 7, 8 ist nicht auf zwei begrenzt. Abhängig von den Pinch-Off-Spannungen der eingesetzten Transistoren können auch nur eine Diode oder auch mehr als zwei Dioden in Serie geschaltet werden. Sowohl in Figur 1 als auch in Figur 2 werden Erfindungsgemäß jeweils zumindest ein Transistor eingesetzt, welcher selbstleitend ist.

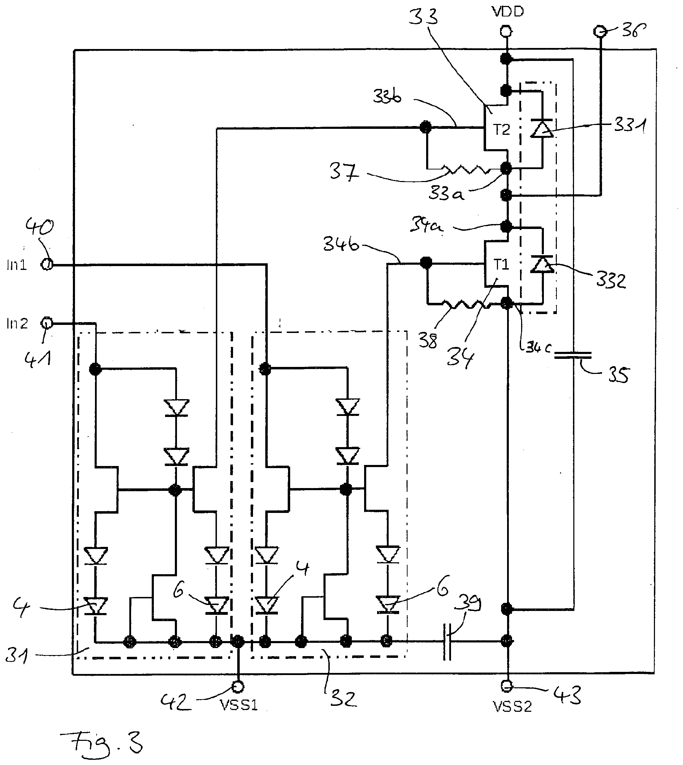

Figur 3 zeigt eine halbe H-Brücke mit zwei Stromspiegeln 31, 32 entsprechend Figur 2. Die Transistoren der H-Brücke, also die weiteren Transistoren sind die Transistoren 33 und 34. Hierbei ist der eine der Transistoren über seinen Drain-Kontakt mit dem Source-Kontakt des anderen Transistors verbunden. Der Source-Kontakt der weiteren Transistoren 33 und 34 ist über eine Freilaufdiode 331 bzw. 332 jeweils mit dem Drain-Kontakt des entsprechenden Transistors verbunden. Darüber hinaus sind jene Kontakte von Source- und Drain-Kontakten der Transistoren 33 und 34 über einen Kondensator 35 miteinander verbunden, mit welchen sie nicht unmittelbar miteinander verbunden sind. Die halbe H-Brücke erzeugt eine Ausgangsspannung Uₒᵤₜ 36 zwischen den beiden weiteren Transistoren 33 und 34 dort, wo sie direkt miteinander kontaktiert sind. Im gezeigten Beispiel fällt die Ausgangsspannung 36 also sowohl am Kontakt 33a wie auch am Kontakt 34a des Transistors 33 und dem hiermit direkt verbundenen Kontakt 34a des Transistors 34 ab.

Der Kondensator 35 und die Freilaufdioden 331, 332 schützen die Schaltung vor negativen Überspannungsspitzen und verbessern die Spannungsquelleneigenschaften an den Spannungsversorgungspunkten. Dies ist insbesondere wichtig, wenn die Schaltung als integrierte Schaltung ausgeführt wird.

Ein Gate-Kontakt 33b des Transistors 33 ist mit dem Kontakt 33a des Transistors 33 über einen Widerstand 37 verbunden. Entsprechend ist ein Gate-Kontakt 34b des Transistors mit einem Kontakt 34c des Transistors über den Widerstand 38 verbunden. Ein weiterer Kondensator 39 ist mit den Dioden 4, 6 und dem Bypasstransistor 9 einerseits sowie andererseits mit dem Kontakt 34c des Transistors 34 in Kontakt. In der gezeigten halben H-Brücke erwarten die Eingänge 40 und 41 einen Schaltstrom, welcher gespiegelt über die Stromspiegel 31 und 32 die Transistoren 33 und 34 der H-Brücke steuert. Die Stromspiegel 31 und 32 des Steuerstroms sind am Knoten 42 (VSS1) mit einem negativeren Potential verbunden als der Masseanschluss 43 (VSS2) der halben H-Brücke. Die gespiegelten Steuerströme werden über die am Gate 33b und Source 33a bzw. 34b und 34c angeschlossenen Widerstände 37 und 38 in Steuerspannungen umgesetzt. Die Kondensatoren 35 und 39 dienen als Stützkondensatoren.

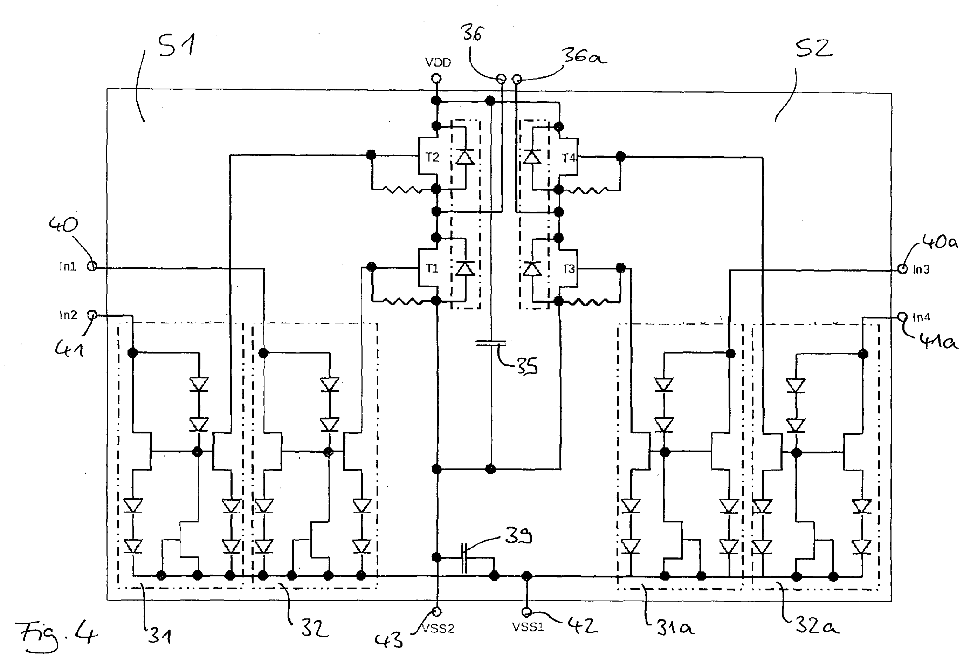

Figur 4 zeigt eine volle H-Brücke mit zwei halben - Brücken 51 und 52, wie sie in Figur 3 gezeigt sind. Die halben H-Brücken 51 und 52 teilen sich die gemeinsame Masse 43 sowie das Referenzpotential am Punkt 42. Darüber hinaus teilen sich beide halben H-Brücken 51 und 52 die Kondensatoren 35 und 39. Insgesamt weist die volle H-Brücke vier Stromspiegel 31, 32, 31a, 32a, wie sie in Figur 2 gezeigt sind, auf. Durch Einprägen von Strom in die Eingänge 40, 41, 40a und 41a lässt sich zwischen den Ausgangsanschlüssen 36 und 36a eine Spannung mit umkehrbarem Vorzeichen erzeugen. Wird beispielsweise ein Strom in die Eingänge 41 und 40a eingeleitet, so liegt zwischen den Punkten 36 und 36a eine Spannung mit einer Polarität an, während, wenn ein Strom in die Eingänge 40 und 41a geleitet wird, an den Punkten 36 und 36a eine Spannung mit entgegengesetztem Vorzeichen anliegt.

## Patentansprüche

1. Stromspiegel, umfassend:
zwei Transistoren (1, 2), von denen einer ein Referenztransistor (1) und einer ein Spiegeltransistor (2) ist, sowie
ein Bypass-Transistor (9), dessen Drain-Kontakt einen Gate-Kontakt von zumindest einem der beiden Transistoren (1, 2) kontaktiert,
wobei zumindest einer der beiden Transistoren (1, 2) ein selbstleitender Transistor ist,
wobei ein Gate-Kontakt des Bypass-Transistors (9) mit dem Source-Kontakt des Bypass-Transistors (9) kontaktiert ist, und
wobei ein Drain-Kontakt des Referenztransistors (11) über eine erste Diode (Db1) in Durchlassrichtung mit einem Gate-Kontakt des Referenztransistors (12) verbunden ist,
**dadurch gekennzeichnet, dass**
zumindest eine zweite Diode (Dr1) zwischen einem Source-Kontakt des Referenztransistors (13) und einer Masse angeordnet ist und anodenseitig mit dem Source-Kontakt des Referenztransistors (13) kontaktiert ist, und dass
zumindest eine dritte Diode (Ds1) zwischen einem Source-Kontakt des Spiegeltransistors (23) und der Masse angeordnet ist und anodenseitig mit einem Source-Kontakt des Spiegeltransistors (23) kontaktiert ist.

2. Stromspiegel nach dem vorhergehenden Anspruch,
**dadurch gekennzeichnet, dass** der zumindest eine selbstleitende Transistor ein selbstleitender n-Kanal-Transistor oder ein selbstleitender p-Kanal-Transistor ist.

3. Stromspiegel nach einem der vorhergehenden Ansprüche,
**dadurch gekennzeichnet, dass** der zumindest eine selbstleitende Transistor, vorzugsweise zumindest ein Kanal des Transistors, zumindest einen Halbleiter aufweist, der zumindest ein Nitrid eines Hauptgruppe-III-Elementes enthält oder daraus besteht.

4. Stromspiegel nach einem der vorhergehenden Ansprüche,
**dadurch gekennzeichnet, dass** ein Gate-Kontakt des Referenztransistors (12) mit einem Gate-Kontakt des Spiegeltransistors (22) kontaktiert ist, vorzugsweise elektrisch unmittelbar kontaktiert ist.

5. Stromspiegel nach einem der vorhergehenden Ansprüche,
**dadurch gekennzeichnet, dass** eine vierte Diode (Dr2) zur zweiten Diode (Dr1) in Serie geschaltet ist.

6. Stromspiegel nach einem der vorhergehenden Ansprüche,
**dadurch gekennzeichnet, dass** eine fünfte Diode (Ds2) zur dritten Diode (Ds1) in Serie geschaltete ist.

7. Stromspiegel nach dem vorhergehenden Anspruch,
**dadurch gekennzeichnet, dass** die Verhältnisse von Flächen der zweiten Diode (Dr1) zur dritten Diode (Ds1) und/oder die Verhältnisse von Flächen der vierten Diode (Dr2) zur fünften Diode (Ds2) gleich einem Verhältnis von Flächen des Spiegeltransistors (2) und des Referenztransistors (1) zueinander ist.

8. Elektrische Schaltung,
**gekennzeichnet durch** zumindest einen Stromspiegel nach einem der vorhergehenden Ansprüche sowie zumindest einem weiteren elektrischen Bauelement.

9. Elektrische Schaltung nach dem vorhergehenden Anspruch,
**dadurch gekennzeichnet, dass** die elektrische Schaltung zumindest einen weiteren Transistor aufweist, der vorzugsweise einen Halbleiter mit einem Nitrid eines Hauptgruppe-III-Elementes aufweist.

10. Elektrische Schaltung nach einem der beiden vorhergehenden Ansprüche,
**dadurch gekennzeichnet, dass** die elektrische Schaltung zumindest eine halbe H-Brücke mit zumindest einem ersten weiteren Transistor und zumindest einem zweiten weiteren Transistor aufweist, wobei ein Source-Kontakt des einen der weiteren Transistoren mit einem Drain-Kontakt des anderen der weiteren Transistoren kontaktiert ist, vorzugsweise elektrisch unmittelbar kontaktiert ist.

11. Elektrische Schaltung nach einem der Ansprüche 8 bis 10,
**dadurch gekennzeichnet, dass** die Schaltung zwei halbe H-Brücken mit jeweils zumindest einem ersten weiteren Transistor und zumindest einem zweiten weiteren Transistor aufweist, die zu einer ganzen H-Brücke gekoppelt sind, wobei die Source-Kontakte der ersten weiteren Transistoren elektrisch kontaktiert sind, vorzugsweise elektrisch unmittelbar kontaktiert sind, und die Drain-Kontakte der zweiten weiteren Transistoren miteinander kontaktiert sind, vorzugsweise miteinander elektrisch unmittelbar kontaktiert sind.

12. Elektrische Schaltung nach einem der Ansprüche 8 bis 11,
**dadurch gekennzeichnet, dass** der Source- und der Drain-Kontakt des ersten und/oder des zweiten weiteren Transistors zumindest einer der halben H-Brücken über jeweils zumindest eine Freilaufdiode miteinander elektrisch verbunden sind, vorzugsweise elektrisch unmittelbar miteinander verbunden sind.

13. Elektrische Schaltung nach einem der Ansprüche 8 bis 12,
**dadurch gekennzeichnet, dass** ein Gate-Kontakt des ersten und/oder des zweiten weiteren Transistors zumindest einer der halben H-Brücken mit einem Drain-Kontakt eines Spiegeltransistors eines der Stromspiegel verbunden ist, vorzugsweise elektrisch unmittelbar verbunden ist.

## Claims

1. A current mirror comprising:
two transistors (1, 2),
wherein one is a reference transistor (1) and one is a mirror transistor (2), and
a bypass transistor (9), whose drain contact contacts a gate contact of at least one of the two transistors (1, 2),
wherein at least one of the two transistors (1, 2) is a self conducting transistor,
wherein a gate contact of the bypass transistor (9) is contacted with a source contact of the bypass-transistors (9), and
wherein a drain contact of the reference transistor (11) is connected in forward direction with a gate contact of the of the reference transistor (12) via a first diode (Db1),
**characterized in that**
at least a second diode (Dr1) is arranged between a source contact of the reference transistor (13) and a ground and is contacted on the anode side with the source contact of the reference transistor (13), and **in that**
at least one third diode (Ds1) is arranged between a source contact of the mirror transistor (23) and the ground and is contacted on the anode side with a source contact of the mirror transistor (23).

2. The current mirror according to the previous claim,
**characterized in that** the at least one self conducting transistor is a self conducting n-channel transistor or a self conducting p-channel transistor.

3. The current mirror according to one of the preceding claims,
**characterized in that** the at least one self conducting transistor, preferably at least one channel of the transistor, comprises at least one semiconductor containing or consisting of at least a nitride of a main group-III-element.

4. The current mirror according to one of the preceding claims,
**characterized in that** one gate contact of the reference transistor (12) is contacted with a gate contact of the mirror transistor (22), preferably directly electrically contacted.

5. The current mirror according to one of the preceding claims,
**characterized in that** a fourth diode (Dr2) is connected in series with the second diode (Dr1).

6. The current mirror according to one of the preceding claims,
**characterized in that** a fifth diode (Ds2) is connected in series with the third diode (Ds1).

7. The current mirror according to the previous claim,
**characterized in that** the ratios of surfaces of the second diode (Dr1) to the third diode (Ds1) and/or the ratios of surfaces of the fourth diode (Dr2) to the fifth diode (Ds2) are equal to a ratio of surfaces of the mirror transistor (2) and the reference transistor (1) to one another.

8. An electrical circuit,
**characterized by** at least one current mirror according to one of the preceding claims and at least one further electrical component.

9. The electric circuit according to the previous claim,
**characterized in that** the electrical circuit comprises at least one further transistor preferably comprising a semiconductor with a nitride of a main group-III-element.

10. The electric circuit according to one of the two preceding claims,
**characterized in that** the electrical circuit comprises at least one half H-bridge with at least one first further transistor and at least one second further transistor, wherein a source contact of one of the further transistors being contacted with a drain contact of the other of the further transistors, preferably being contacted directly electrically.

11. The electrical circuit according to one of the claims 8 to 10,
**characterized in that** the circuit comprises two half H-bridges, each comprising at least one first further transistor and at least one second further transistor, which are coupled to an entire H-bridge, wherein the source contacts of the first further transistors being electrically contacted, preferably being electrically directly contacted, and the drain contacts of the second further transistors being contacted with one another, preferably being electrically directly contacted with one another.

12. The electrical circuit according to one of the claims 8 to 11,
**characterized in that** the source contact and the drain contact of the first and/or the second further transistor of at least one of the half H-bridges are each electrically connected to one another via at least one flyback diode, or preferably directly electrically connected to one another.

13. The electric circuit according to one of the claims 8 to 12,
**characterized in that** a gate contact of the first and/or the second further transistor of at least one of the half H-bridges is connected to a drain contact of a mirror transistor of one of the current mirrors, preferably directly electrically connected.

## Revendications

1. Miroir de courant, comprenant :
deux transistors (1, 2) desquels l'un est un transistor de référence (1) et l'un est un transistor miroir (2), ainsi
qu'un transistor de bypass (9), dont le contact de drain entre en contact avec un contact de grille d'au moins un des deux transistors (1, 2),
dans lequel au moins un des deux transistors (1, 2) est un transistor autoconducteur,
dans lequel un contact de grille du transistor de bypass (9) entre en contact avec le contact de source du transistor de bypass (9), et
dans lequel un contact de drain du transistor de référence (11) est raccordé à un contact de grille du transistor de référence (12) par le biais d'une première diode (Db1) dans le sens direct,
**caractérisé en ce**
**qu'**au moins une deuxième diode (Dr1) est agencée entre un contact de source du transistor de référence (13) et une masse et entre en contact avec le contact de source du transistor de référence (13) côté anode, et en ce
**qu'**au moins une troisième diode (Ds1) est agencée entre un contact de source du transistor miroir (23) et une masse et entre en contact avec le contact de source du transistor miroir (23) côté anode.

2. Miroir de courant selon la revendication précédente,
**caractérisé en ce que** l'au moins un transistor autoconducteur est un transistor autoconducteur à canal N ou un transistor autoconducteur à canal P.

3. Miroir de courant selon l'une des revendications précédentes,
**caractérisé en ce que** l'au moins un transistor autoconducteur, de préférence au moins un canal du transistor, comporte au moins un semi-conducteur, lequel contient au moins un nitrure d'un élément du groupe IIIA ou en est constitué.

4. Miroir de courant selon l'une des revendications précédentes,
**caractérisé en ce qu'**un contact de grille du transistor de référence (12) entre en contact avec un contact de grille du transistor miroir (22), de préférence en contact électrique direct.

5. Miroir de courant selon l'une des revendications précédentes,
**caractérisé en ce qu'**une quatrième diode (Dr2) est branchée en série par rapport à la deuxième diode (Dr1).

6. Miroir de courant selon l'une des revendications précédentes,
**caractérisé en ce qu'**une cinquième diode (Ds2) est branchée en série par rapport à la troisième diode (Ds1).

7. Miroir de courant selon l'une des revendications précédentes,
**caractérisé en ce que** le ratio de surface de la deuxième diode (Dr1) par rapport à la troisième diode (Ds1) et/ou le ratio de surface de la quatrième diode (Dr2) par rapport à la cinquième diode (Ds2) est égal à un ratio de surface du transistor miroir (2) et du transistor de référence (1) l'un par rapport à l'autre.

8. Circuit électrique,
**caractérisé par** au moins un miroir de courant selon l'une des revendications précédentes ainsi qu'au moins un composant électrique supplémentaire.

9. Circuit électrique selon la revendication précédente,
**caractérisé en ce que** le circuit électrique comporte au moins un transistor supplémentaire, lequel comporte de préférence un semi-conducteur avec un nitrure d'un élément du groupe IIIA.

10. Circuit électrique selon l'une des deux revendications précédentes,
**caractérisé en ce que** le circuit électrique comporte au moins un demi-pont en H avec au moins un premier transistor supplémentaire et au moins un deuxième transistor supplémentaire, dans lequel un contact de source d'un des transistors supplémentaires entre en contact avec un contact de drain de l'autre transistor supplémentaire, de préférence en contact électrique direct.

11. Circuit électrique selon l'une des revendications 8 à 10,
**caractérisé en ce que** le circuit comporte deux demi-ponts en H avec respectivement au moins un premier transistor supplémentaire et au moins un deuxième transistor supplémentaire, lesquels sont couplés en un pont en H entier, dans lequel les contacts de source des premiers transistors supplémentaires entrent en contact, de préférence en contact électrique direct, et les contacts de drain des deuxièmes transistors supplémentaires entrent en contact l'un avec l'autre, de préférence en contact électrique direct l'un avec l'autre.

12. Circuit électrique selon l'une des revendications 8 à 11,
**caractérisé en ce que** le contact de source et le contact de drain du premier et/ou du deuxième transistor supplémentaire d'au moins un des demi-ponts en H sont raccordés électriquement l'un à l'autre respectivement par le biais d'au moins une diode de roue libre, de préférence raccordés électriquement directement l'un à l'autre.

13. Circuit électrique selon l'une des revendications 8 à 12,
**caractérisé en ce qu'**un contact de grille du premier et/ou du deuxième transistor supplémentaire d'au moins un des demi-ponts en H est raccordé à un contact de drain d'un transistor miroir du miroir de courant, de préférence électriquement directement raccordé.
